# EUROPÄISCHE PATENTSCHRIFT

(11) **EP 2 335 275 B1**
(45) Veröffentlichungstag und Bekanntmachung des Hinweises auf die Patenterteilung: **11.12.2013**
(21) Anmeldenummer: 09783544.1
(22) Anmeldetag: 29.09.2009
(51) Int. Cl.: C23F 1/00, H01L 21/67, H01L 21/00, H01L 31/18, H01L 21/306

(54) **VERFAHREN ZUR CHEMISCHEN BEHANDLUNG EINES SUBSTRATS**
METHOD FOR CHEMICALLY TREATING A SUBSTRATE
PROCÉDÉ DE TRAITEMENT CHIMIQUE D UN SUBSTRAT

(30) Priorität: 30.09.2008 DE 102008037404
(43) Veröffentlichungstag der Anmeldung: 22.06.2011
(73) Patentinhaber: Fraunhofer Gesellschaft zur Förderung der angewandten Forschung e.V., 80686 München (DE)
(72) Erfinder: TEPPE, Andreas, 78467 Konstanz (DE); SCHUM, Berthold, 63599 Biebergemünd (DE); FRANKE, Dieter, NL-6291 BL Vaals (NL); SCHWIRTLICH, Ingo, 63897 Miltenberg (DE); VAAS, Knut, 63755 Alzenau (DE); SCHMIDT, Wilfried, 74193 Schwaigern (DE)
(86) Internationale Anmeldenummer: PCT/EP2009/062608
(87) Internationale Veröffentlichungsnummer: WO 2010/037739

(56) Entgegenhaltungen:
- EP-A- 1 746 639
- WO-A-2005/093788
- DE-A1- 10 313 127
- US-A1- 2008 041 725

## Beschreibung

Die Erfindung bezieht sich auf ein Verfahren zur chemischen Behandlung eines eine Unterseitenfläche, Oberseitenfläche und Seitenflächen aufweisenden vorzugsweise scheiben- oder plattenförmigen Substrats durch Kontaktieren eines flüssigen chemisch wirksamen Prozessmediums mit zumindest der Unterseitenfläche des Substrats, wobei das Substrat relativ zum Prozessmedium bei gleichzeitiger Ausbildung einer Tripellinie zwischen Substrat, dem Prozessmedium und diese umgebender Atmosphäre bewegt wird und eine chemische Abtragsreaktion erzielt wird.

Nach dem Stand der Technik sind eine Vielzahl von Durchlaufverfahren zur chemischen Behandlung von plattenförmigen Bauteilen bekannt, bei denen durch ein Prozessmedium eine chemische Reaktion mit den Oberflächen des Bauteils eingestellt wird. In der Halbleiterindustrie sind dies besonders Ätzverfahren zur chemischen Reinigung und Strukturierung von Halbleitermaterialien, im besonderen Anwendungsgebiet der Photovoltaik die chemische Behandlung von großflächigen und dünnen Siliziumscheiben.

Verfahren der Halbleiterindustrie beaufschlagen die Scheibenoberflächen vornehmlich mit gasförmigen Prozessmedien und/oder flüssigen Prozessmedien.

Es sind Verfahren bekannt, bei denen die Scheibenoberflächen mit gasförmigen Prozessmedien so beaufschlagt werden, dass die gesamten Oberflächen des Substrates eine chemische Reaktion mit dem gasförmigen Medium eingehen. Ein Beispiel hierfür ist das Einbringen in eine flusssäuredampfhaltige Atmosphäre, wobei auf der Substratoberfläche vorhandene Oxidschichten abgetragen werden. Eine selektive Behandlung von Vorderund/oder Rückseiten und/oder Kanten des Substrates ist mit dem Verfahren - wenn überhaupt - nur unzulänglich möglich. Ein unvollständiger Schutz einer Substratseite vor Benetzung mit dem Prozessmedium kann durch das Auflegen des Substrates auf eine flächige Unterlage teilweise erreicht werden, indem im Bereich der Auflagefläche eine Beaufschlagung mit dem gasförmigen Medium teilweise unterdrückt werden kann. Des Weiteren besteht die Möglichkeit der Fläche-auf-Fläche-Positionierung von jeweils zwei scheibenförmigen Substraten, so dass die Kontaktfläche der beiden Substrate zueinander von der Benetzung mit einem gasförmigen Prozessmedium teilweise ausgenommen werden kann.

Auch ist die Behandlung von einer Scheibenoberfläche durch chemisch mit der Oberfläche reagierende flüssige Medien bekannt (WO-A-2007/073886, WO-A-2007/073887), wobei durch Walzen das flüssige Medium an die Scheibenfläche transportiert und gezielt ausschließlich die der Flüssigkeit zugewendete Scheibenseite benetzt wird.

Ferner sind Verfahren bekannt, bei denen die Scheiben auf dünnen Transportrollen bewegt werden, wobei der Kontakt des flüssigen Mediums zur untenliegenden Scheibenoberfläche durch Benetzen an der Flüssigkeitsoberfläche unter Ausbildung eines Flüssigkeitsmeniskus nach unten gerichtet von der Kante der Scheibe zum Flüssigkeitsvolumen hin eingestellt wird. Bei entsprechenden Verfahren bleiben die Scheibenkanten von der chemischen Reaktion ausgenommen und werden allerhöchstens unkontrolliert und dabei nicht reproduzierbar behandelt.

Weisen dünne Substrate wie Wafer Beschädigungen bzw. Fehler in den Seitenflächen auf, so ist beim weiteren Handling festzustellen, dass die Substrate von den Seitenflächen ausgehend beschädigt werden bzw. Bereiche ausbrechen.

Der DE-A-103 13 127 ist ein Verfahren zur Verhinderung der Kurzschlussbildung bei Siliziumscheiben zu entnehmen. Zum Prozessieren werden die Unterseiten und gegebenenfalls die Kanten der Scheiben in ein Ätzbad abgesenkt.

Die Unterseitenfläche sowie die Seitenflächen einer Siliziumscheibe werden nach der WO-A-2005/093788 im Durchlaufverfahren kontinuierlich prozessiert, indem die Siliziumscheiben auf Transportrollen durch ein Flüssigkeitsbad gefördert werden.

Die DE-A-44 23 326 bezieht sich auf ein Verfahren zum Rückseitenätzen einer Silizium-Waferstruktur. Hierzu wird ein Substrat in einer Haltevorrichtung fixiert, um sodann eine Seite mit einem Ätzmedium und die andere Seite mit Stickstoff zu beaufschlagen.

Um leitendes Material von einem Wafer zu entfernen, wird nach der US-A-2008/0041725 eine Elektrolytflüssigkeit benutzt, ohne dass eine Spannung angelegt wird.

Die DE-A-103 13 127 bezieht sich auf ein Verfahren zur Behandlung von Substratoberflächen, wobei Ober- oder Unterseite prozessiert werden können.

Gegenstand der EP-A-1 746 639 ist ein Verfahren zum Ätzen eines Wafers, der oberflächenseitig mit einer Ätzflüssigkeit beaufschlagt wird.

Der vorliegenden Erfindung liegt die Aufgabe zugrunde, ein Verfahren zuvor beschriebener Art so weiterzubilden, dass insbesondere in den Seitenflächen vorhandene Fehler chemisch entfernt werden, so dass beim weiteren Handling eine Bruchreduzierung gegeben ist. Dabei soll das chemische Behandeln in einem kontinuierlichen Durchlaufprozess durchgeführt werden, um verfahrensmäßig ökonomisch zu arbeiten. Gleichzeitig soll vermieden werden, dass die Oberseitenfläche des Substrats bei der Behandlung der Seitenfläche in eine chemische Reaktion mit einbezogen wird.

Erfindungsgemäß wird die Aufgabe durch das Verfahren nach Anspruch 1 gelöst. Insbesondere wird die Aufgabe erfindungsgemäß im Wesentlichen dadurch gelöst, dass die Relativbewegung unter Vermeidung eines Kontaktierens des Prozessmediums mit der Oberseitenfläche des Substrats durchgeführt wird, dass die Tripellinie in Bezug auf die Relativbewegung zwischen dem Substrat und dem Prozessmedium auf gewünschter Höhe an prozessmediumströmungsseitig abgewandter Seitenfläche ausgebildet wird, dass die Atmosphäre in Bezug auf Partialdrücke von in dem Prozessmedium vorhandenen Komponenten derart eingestellt wird, dass die Oberseitenfläche hydrophobe Eigenschaften bewahrt oder in der Oberseitenfläche hydrophobe Eigenschaften ausgebildet werden und/oder und dass das Substrat vorzugsweise während der Relativbewegung zu dem Prozessmedium in einem Umfang gedreht wird, dass von jeder zwischen der Oberseitenfläche und den Seitenflächen verlaufenden Kante oder im Bereich der Seitenflächen während der chemischen Behandlung eine Tripellinie ausgeht. Insbesondere ist vorgesehen, dass die Tripellinie an prozessmediumströmungsseitig abgewandter Kante zwischen der Oberseitenfläche und Seitenfläche des Substrats ausgebildet wird.

Erfindungsgemäß wird ein Verfahren zur chemischen Behandlung dünner plattenförmiger bzw. scheibenförmiger Substrate, insbesondere zur Behandlung von Substraten für die Herstellung von Solarzellen zur Verfügung gestellt, bei dem in einem kontinuierlichen Durchlaufverfahren die Bruchempfindlichkeit reduziert wird. Durch die verfahrenstypische Prozessierung werden sowohl die Unterseitenfläche als auch die Seitenflächen des Substrats in einem kontinuierlichen Durchlaufverfahren gleichzeitig so behandelt, dass durch die Benetzung mit einem chemisch wirksamen Prozessmedium eine chemische Reaktion ausschließlich mit der Unterseitenflächen und den Seitenflächen des Substrats in einem Arbeitsschritt erfolgt, ohne dass die Oberseitenfläche in eine chemische Reaktion mit einbezogen wird.

Gegenüber dem Stand der Technik ergibt sich der Vorteil, dass sowohl die Unterseitenfläche als auch die Seitenflächen eines scheiben- oder plattenförmigen also dünnen Substrats in einem kontinuierlichen Durchlaufverfahren in einem einzigen Verfahrensschritt für seine weitere Verwendung chemisch behandelt werden, wobei jedoch eine Kontamination der Oberseitenfläche während der chemischen Behandlung vermieden bzw. unterdrückt wird. Es erfolgt eine gezielte Einstellung der Relativbewegung zwischen dem Substrat und dem Prozessmedium derart, dass die Tripellinie zwischen dem Substrat, dem Prozessmedium und der Atmosphäre oberhalb des Prozessmediums in einer in Bezug auf die Strömungsrichtung gewünschten Höhe der Rückseitenfläche, insbesondere an der hinteren oberen Kante der Rückseitenfläche entsteht, so dass entsprechend die Seitenfläche neben der Unterseitenfläche mit dem Prozessmedium chemisch reagiert mit der Folge, dass eine Oberflächenbehandlung und somit das Entfernen von Materialschäden wie z.B. Rissen, Mikrorissen oder Oberflächenrauigkeit und Texturen, Oxiden oder sonstigen für die weiteren Prozessschritte unerwünschten Bereichen abgetragen werden. Hierdurch ist eine Optimierung bzgl. der Durchführung der weiteren Prozessschritte insbesondere bei der Herstellung von Solaizellen bei gleichzeitiger Reduzierung der Bruchempfindlichkeit gegeben.

Insbesondere besteht aufgrund der erfindungsgemäßen Lehre die Möglichkeit, dass bei einem dotierten Halbleitersubstrat ein Abtragen der Unterseiten- und Seitenflächen während der Prozessierung in dem Prozessmedium in einem Umfang erfolgt, dass die dotierte Schicht, insbesondere bei einem für eine Solarzelle bestimmten Halbleitersubstrat der pn- bzw. np-Übergang abgetragen wird, ohne dass dieser im Bereich der Oberseitenfläche vorhandene pn- bzw. np-Übergang angegriffen wird.

Insbesondere ist dabei vorgesehen, dass zur Vermeidung einer Kontamination der Vorderseitenfläche durch das Prozessmedium die die Oberseitenfläche umgebende Atmosphäre im Reaktionsraum derart eingestellt wird, dass die in der Atmosphäre vorhandenen Komponenten, die aus dem Prozessmedium austreten, Partialdrücke aufweisen, dass sich in der Oberseitenfläche hydrophobe Eigenschaften ausbilden bzw. entsprechende Eigenschaften bewahrt werden.

Hierzu ist insbesondere vorgesehen, dass die Atmosphäre mit den in dem Reaktionsraum vorhandenen Säuredämpfen derart ausgetauscht wird, dass der Dampfdruck der Säurekomponenten, die in Bezug auf das Substrat ätzende Wirkung besitzen, den Anteil der Komponenten des Prozessmediums der Säure übersteigt, die oxidative Eigenschaften zeigen.

Enthält das Prozessmedium Flusssäure und Salpetersäure, so sollte der Partialdruck der Komponenten gleich sein, so dass der Anteil der HF-Moleküle die der HNO₃-Moleküle übersteigt. Hierdurch erfolgt ein Abätzen der Oberseitenfläche mit der Folge, dass vorhandene Oxidschichten abgetragen werden und sich somit hydrophobe Eigenschaften ergeben.

Es werden folglich dünne platten- bzw. scheibenförmige Substrate gleichzeitig nur an der Unterseitenfläche und den Seitenflächen in einem kontinuierlichen dynamischen Prozess mit einer chemisch wirksamen Flüssigkeit derart benetzt, dass sich eine chemische Abtragsreaktion an den Benetzunasflächen bei gleichzeitig bestehendem Partialdruck von Komponenten der chemisch wirksamen Flüssigkeit in der Atmosphäre oberhalb des Substrats, also in dem Reaktionsraum, in dem das Durchlaufverfahren durchgeführt wird, einstellt, um eine weitere chemische Reaktion zur Erzielung einer Hydrophobierung zu ermöglichen.

Ohne die Erfindung zu verlassen, besteht dabei die Möglichkeit, eine Hydrophobierung der Oberseitenflächen bereits vor Benetzung der Unterseitenfläche sowie der Seitenflächen mit dem Prozessmedium zu erreichen. So kann gegebenenfalls ein Vorbehandlungsschritt vorgesehen sein, um zumindest die Oberseitenfläche, gegebenenfalls sämtliche Flächen des Substrats, mit einer geeigneten Chemikalie so zu behandeln, dass sich hydrophobe Eigenschaften einstellen. Hierdurch wird bei dem kontinuierlichen Durchlaufverfahren an der zu der Bewegungsrichtung abgewandten Seitenfläche eine Flüssigkeitserhöhung verstärkt, so dass sich die gewünschte Tripellinie an der hinteren Seitenfläche, insbesondere Oberkante des Substrats zur Begrenzung des chemischen Abtrags auf der Seitenfläche von Beginn des chemischen Angriffs an einstellt. In der Tripellinie treffen die Substratoberfläche, das flüssige Prozessmedium und die gasförmige Umgebungsatmosphäre zusammen.

Durch das Vorhandensein der Tripellinie an der oberen Kante des Substrats wird die maximale Benetzungsfläche des Substrats auf seine Unterseitenfläche einschließlich der Seitenflächen beschränkt.

Damit vorzugsweise jede Seitenfläche im erforderlichen Umfang chemisch behandelt wird, wird das Substrat während des Durchlaufprozesses um eine senkrecht zur von dem Substrat aufgespannten Ebene verlaufende Achse im erforderlichen Umfang gedreht. Bei einem rechteckförmigen Substrat erfolgt dreimal ein Drehen um jeweils 90 °, um sämtliche Seitenflächen behandelt zu haben. Handelt es sich um ein in Draufsicht kreisförmiges Substrat, so wird diese in einem Umfang gedreht, dass die gesamte umlaufende Seitenfläche im gewünschten Umfang prozessiert wird. In diesem Sinne ist unter Seitenflächen auch eine umlaufende Seitenfläche der zuvor erläuterten Art zu verstehen.

Das Drehen des Substrats wird auch dann verwirklicht und ist in diesem Sinne zu verstehen, wenn das Substrat nach dem Prozessieren eines der Seitenflächen aus dem Prozessmedium herausgenommen, gedreht und sodann erneut durch das oder ein anderes Prozessmedium geführt wird.

Erfindungsgemäß erfolgt eine Relativbewegung zwischen dem Substrat und dem Prozessmedium derart, dass sich eine Heckwelle ausbildet, die dann, wenn die Seitenflächen vollständig chemisch behandelt werden sollen, an der oberen Kante der in Bezug auf die Bewegungsrichtung rückseitigen Seitenfläche verläuft.

Ist vorzugsweise vorgesehen, dass das Substrat ein Halbleitersubstrat, insbesondere Silizium-Halbleitersubstrat ist, so wird die erfindungsgemäße Lehre hierauf nicht beschränkt. Vielmehr sind alle Materialien geeignet, bei denen durch chemische Reaktion ein Oberflächenabtrag ermöglicht wird.

Unabhängig hiervon sollte das Substrat in Draufsicht eine quadratische, pseudo-quadratische, rechteckige oder kreisförmige Geometrie aufweisen, wobei die Substratdicke insbesondere im Bereich zwischen 50 µm und 500 µm, vorzugsweise jedoch zwischen 100 µm und 200 µm liegt.

Wird ein in Draufsicht eine eckige Geometrie aufweisendes Substrat prozessiert, so sollte zumindest eine Kante, vorzugsweise jede Kante eine Länge im Bereich zwischen 100 mm und 350 mm, vorzugsweise zwischen 125 mm und 156 mm aufweisen. Somit ist das erfindungsgemäße Verfahren insbesondere für Wafer geeignete, die für Solarzellenherstellung bestimmt sind.

Besteht die Möglichkeit, das Prozessmedium zu dem Substrat strömen zu lassen, so wird vorzugsweise das Substrat durch das Prozessmedium geführt. Selbstverständlich besteht auch die Möglichkeit, zum einen das Prozessmedium strömen zu lassen und zum anderen das Substrat entgegen der Strömungsrichtung des Prozessmediums zu bewegen.

Als Prozessmedium wird ein solches verwendet, das als Komponenten zumindest eine wässrige Säure mit in Bezug auf das Substrat oxidativer Wirkung und zumindest eine wässrige Säure mit in Bezug auf das Oxid des Substrats komplexierender Wirkung enthält. Insbesondere sollte das Prozessmedium Komponenten aus der Gruppe H₂O, HF, HNO₃, HCl, Oxidationsmittel wie H₂O₂, NO₂, Ammoniumfluorid, Essigsäure, Schwefelsäure, Phosphorsäure enthalten. Vorzugsweise enthält das Prozessmedium bei der Prozessierung von Substraten, die Silizium enthalten oder aus Silizium bestehen, wässrige Flusssäure und wässrige Salpetersäure.

Unabhängig hiervon sollten die Säurebestandteile einen Anteil zwischen 0,1 Vol.% und 70 Vol.% aufweisen, wobei die Summe sämtlicher Komponenten des Prozessmediums 100 Vol.% beträgt.

Bezüglich HF und HNO₃ als Komponenten ist vorgesehen, dass der Anteil von HF zwischen 1,0 Gew.% und 20 Gew.% und der Anteil von HNO₃ zwischen 20 Gew.% und 70 Gew.% beträgt, jeweils gleichfalls bezogen auf 100 Gew.% sämtlicher Komponenten.

Besonders gute Ergebnisse lassen sich dann erzielen, wenn der Gewichtsanteil von HF zu HNO₃ sich verhält wie 1:8 ≤ HF:HNO₃ ≤ 1:3. Hierdurch bildet sich beim Prozessieren eine Atmosphäre oberhalb des Prozessmediums, also in dem Bereich des Reaktionsraums aus, in dem sich die unbenetzte Oberseitenfläche des Substrats befindet, die ein Abätzen der Oberseitenfläche mit der Folge bewirkt, dass Oxidschichten entfernt werden und somit hydrophobe Eigenschaften gegeben sind.

Es besteht jedoch auch die Möglichkeit, ein Substrat zu veiwenden, das zumindest in Bezug auf die Oberseitenfläche derart strukturiert ist, dass sich ein Lotusblüteneffekt ergibt, also die gewünschten hydrophoben Eigenschaften. In diesem Fall stellt die ätzend wirkende Atmosphäre sicher, dass die hydrophoben Eigenschaften beibehalten bleiben.

Unabhängig hiervon sollte die Behandlung bei einer Temperatur T des Prozessmediums mit 5 °C ≤ T ≤ 45 °C, vorzugsweise 1.0 °C ≤ T ≤ 25 °C, durchgeführt werden. Als besonders bevorzugt ist jedoch ein Temperaturbereich anzugeben, der unterhalb der Raumtemperatur liegt, also in dem Bereich zwischen 5 °C ≤ T < T_{R}.

Wird das Substrat vorbehandelt, um gewünschte hydrophobe Eigenschaften einzustellen, so sollte bei einem Siliziumsubstrat eine wässrige Lösung von Flusssäure zum Einsatz gelangen, die eine Konzentration zwischen 0,1 Gew.% und 40 Gew.%, vorzugsweise zwischen 1 Gew.% und 10 Gew.% aufweist. Die Prozesstemperatur sollte dabei zwischen 5 °C und 65 °C, insbesondere zwischen 20 °C und 45 °C, vorzugsweise zwischen 20 °C und 40 °C liegen.

Als bevorzugte Vorprozessierzeiten sind Zeiträume zwischen 1 sec. und 10 min., insbesondere zwischen 5 sec. und 60 sec. zu nennen.

Bei dem kontinuierlichen Durchlaufprozess sollte die Relativgeschwindigkeit V zwischen dem Substrat und dem Prozessmedium zwischen 0,1 m/min. und 10 m/min., vorzugsweise zwischen 0,5 m/min. und 5 m/min. betragen.

Die Gesamtprozesszeit ohne eine etwaige Vorbehandlung sollte zwischen 5 sec. und 10 min., insbesondere zwischen 15 sec. und 5 min. betragen.

Während der Prozessierung der Substratunterseitenfläche sowie der Seitenflächen sollte die Atmosphäre durch Zugabe inaktiver und/oder reaktiver Gaskomponenten derart verändert werden, dass sich eine ätzende Wirkung von der auf die Oberflächenseite einwirkende Atmosphäre ergibt.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung eines der Zeichnung zu entnehmenden bevorzugten Ausführungsbeispiels.

Es zeigen:

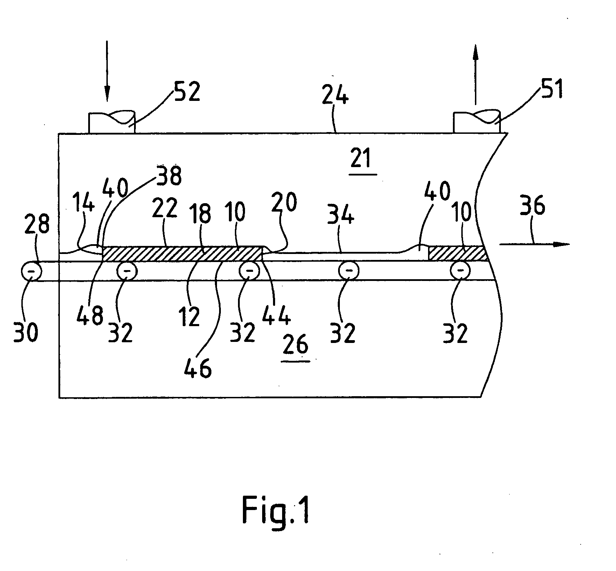

- Fig. 1: eine Prinzipdarstellung eines Reaktionsraums zur chemischen Behandlung von Substraten im Ausschnitt und im Schnitt,
- Fig. 2: einen Abschnitt eines Substrats vor dessen Behandlung,
- Fig. 3: ein Substrat während dessen Relativbewegung in einem chemisch wirkenden flüssigen Prozessmedium,
- Fig. 4: ein Substrat während der chemischen Behandlung nach bereits teilweise abgetragenen Außenflächen,
- Fig.5: ein Vergleich zwischen einem chemisch behandelten Substrat und einem Substrat vor dessen chemischer Behandlung und
- Fig. 6: einen Ausschnitt eines chemisch behandelten Substrats.

Anhand der Figuren, in denen grundsätzlich gleiche Elemente mit gleichen Bezugszeichen versehen sind, soll das erfindungsgemäße Verfahren zur chemischen Behandlung eines Substrats näher erläutert werden, das - ohne die Erfindung einzuschränken - im Ausführungsbeispiel ein aus Silizium bestehendes Substrat 10 die Form eines in Draufsicht rechteckigen Wafers ist, der zur Herstellung einer Solarzelle bestimmt ist. Auch wird nachstehend das Prozessieren der Seitenflächen über ihre gesamten Flächen erläutert, gleichwenn auch gezielt nur ein unterer Teilbereich chemisch behandelt werden könnte. Das Substrat 10 kann vor dessen nachstehend zu erläuternder chemischer Behandlung zuvor allumseitig dotiert sein, um im Abstand zur Ursprungsaußenfläche einen pn-Übergang auszubilden, sofern das Substrat 10 p-leitend ist. Ist das Substrat n-leitend, wird ein np-Übergang durch Dotierung ausgebildet. Das Dotieren erfolgt vorzugsweise in üblicher Weise mit Phosphor- beziehungsweise Bor-enthaltenden Dotierstoffen.

Um entsprechend der erfindungsgemäßen Lehre das Substrat 10 nur in seiner Unterseitenfläche 12 sowie seinen Seitenflächen 14, 16, 18, 20 und nicht in seiner Obenseitenfläche 22 reproduzierbar zu prozessieren, also chemisch zu behandeln, um zum Beispiel Oxidschichten, Materialschäden wie z. B. Risse, Mikrorisse oder Oberflächenrauigkeiten und Texturen, insbesondere in den Seitenflächenbereichen oder den im Bereich der Seitenflächen 14, 16, 18, 20 sowie der Unterseitenfläche 12 verlaufenden pn- bzw. np-Übergang durch Ätzen zu entfernen, wird das Substrat 10 in einem Reaktions- oder Prozessraum 21, der von einem Gehäuse 24 - auch Prozesskammer genannt - umgeben ist, einem flüssigen Prozessmedium 26 ausgesetzt, das im Ausführungsbeispiel für das aus Silizium bestehende Substrat 10 zumindest als Komponenten Flusssäure und Salpetersäure sowie neben H₂O weitere Komponenten wie Oxidationsmittel oder Ammoniumfluorid, Essigsäure, Schwefelsäure, Phosphorsäure oder sonstige Säuren enthalten kann. Wesentlich ist jedoch, dass neben einer oxidativ wirkenden Säure wie HNO₃ auch eine komplexierend wirkende Säure wie HF in dem Prozessmedium 26 enthalten ist.

Das Substrat 10 wird in einem kontinuierlichen dynamischen Prozess durch den Reaktionsraum 21 bei gleichzeitigem Benetzen der Unterseitenfläche 12 sowie in nachstehend beschriebener Weise der Seitenflächen 14, 16, 18, 20 unter Vermeidung eines Benetzens der Oberseitenflächen 22 auf einem Transportband 28 oder einem gleichwirkenden Transportmittel durch den Reaktionsraum 21, also durch das Gehäuse 24 transportiert. Das Prozessmedium 26 wird dabei während der Prozessierung vorzugsweise umgewälzt und in einem Umfang ausgetauscht, dass die gewünschte Konzentration der die chemischen Reaktionen bewirkenden Bestandteile vorliegt. Dabei ist insbesondere vorgesehen, dass die Säurebestandteile im Bereich zwischen 0,1 Vol.% und 70 Vol.% liegen, wobei die Säurekonzentration für HF im Bereich zwischen 0,1 Gew.% und 20 Gew.% und von HNO₃ im Bereich zwischen 20 Gew.% und 70 Gew.% liegen kann. Bei Vorhandensein von HF und HNO₃ sollte deren Verhältnis zwischen 1:8 und 1:3 liegen.

Während des Einwirkens des Prozessmediums 26 auf das Substrat 10 sollte ersteres auf eine Temperatur vorzugsweise unter Raumtemperatur T_{R} zum Beispiel im Bereich 5 °C ≤ T < T_{R} eingestellt werden.

Bevor das Substrat 10 in der Prozesskammer 24 eingeführt wird, kann das eine plattenförmige Quadergeometrie aufweisende Substrat 10 derart vorbehandelt werden, dass sich hydrophobe Oberflächeneigenschaften ergeben. Diese sind wünschenswert, um während des Wechselwirkens mit dem Prozessmedium 26 in der Prozesskammer 24 sicherzustellen, dass die Oberseitenfläche 22 mit dem Prozessmedium 26 nicht benetzt wird.

Die Vorbehandlung erfolgt vorzugsweise außerhalb der Prozesskammer 24 und kann durch Tauchen, Sprühen, Nebeln oder andere Benetzungsverfahren erfolgen, wobei das Tauchverfahren zu bevorzugen ist. Als Prozessmedien, die eine hydrophobe Eigenschaft der Oberfläche bzw. Flächen des Substrats 10 hervorrufen, werden bevorzugt Flusssäure oder vergleichbar wirkende Säuren eingesetzt. Alternativ könnte auch eine Mischung aus Flusssäure und Salpetersäure eingesetzt werden, wodurch eine oxidfreie feinporige Oberflächenschicht auf dem Substrat 10 ausgebildet werden kann, die einen Lotusblüteneffekt zeigt.

Nach der Vorbehandlung, also im Ausführungsbeispiel dem Tauchen, ist bevorzugter Weise vorgesehen, dass ein Abstreifen oder Abblasen der an der Oberfläche des Substrats 10 anhaftenden restlichen Prozessmedien erfolgt, um dessen Verschleppung zu vermeiden bzw. zu reduzieren. Oberfläche bedeutet bei der Vorbehandlung, dass zumindest die Unterseitenfläche sowie die Seitenflächen abgestreift bzw. abgeblasen werden. Im Bedarfsfall können ein Sprühprozess in H₂O und ein Trocknungsprozess in einem Luftstrom vorgesehen sein, wobei in diesem Fall sämtliche Flächen des Substrats 10 behandelt werden. Bei Einsatz eines Luftraums kann dieser eine Temperatur zwischen Raumtemperatur bis 100 °C aufweisen, wobei der bevorzugte Temperaturbereich zwischen 30 °C und 50 °C liegen sollte.

Nach der gegebenenfalls erfolgten Vorbehandlung wird das Substrat 10 über das Transportband 28 oder andere geeignete Transportmedien, das über Rollen 30, 32 oder andere geeignete Systeme geführt bzw. umgelenkt wird, in die Prozesskammer 24 eingeführt, wobei die durch das Transportband 28 vorgegebene Transportebene zum Flüssigkeitsspiegel 34 in Abhängigkeit von der Dicke des Substrats 10 derart eingestellt wird, dass die gesamte Unterseitenfläche 12 sowie bereichsweise die Seitenflächen 14, 16, 18, 20 mit dem Prozessmedium 26 in Berührung gelangen, ohne dass das Prozessmedium 26 die Oberseitenfläche 22 benetzt bzw. entlang dieser verströmt. Die Transportgeschwindigkeit des Substrats 10, das in Richtung des Pfeils 36 durch die Prozesskammer 24 transportiert wird, wird in Abhängigkeit von dem Abstand des der Flüssigkeitsoberfläche 34, also des Flüssigkeitsspiegels, zu der Oberseitenfläche 22 bei durch das Prozessmedium 26 transportiertem Substrat 10 derart eingestellt, dass sich an der Rückseitenfläche 14 eine Heckwelle 40 des Prozessmediums 26 entlang der oberen Kante 38, die zwischen der Rückseitenfläche 14 und der Oberseitenfläche 22 des Substrats 10 verläuft, ausbildet und somit eine Tripellinie 42 entlang der Kante 38 entsteht, in der das Prozessmedium 26, das Substrat 10 und die Atmosphäre ineinander übergehen.

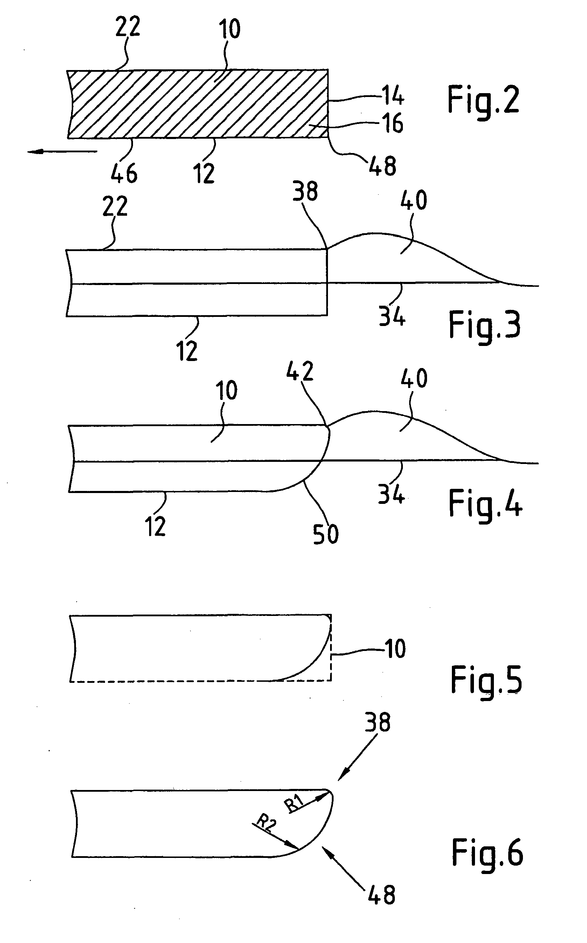

Durch das Einwirken des Prozessmediums 26 auf die Seitenflächen 14, 16, 18, 20 sowie die Unterseitenfläche 12 erfolgt ein Ätzabtrag, der sich an den die Unterseitenfläche 12 begrenzenden Kanten 48 durch einen Abtrag dieser äußert, wie dies durch die Rundung 50 in der Fig. 4 rein prinzipiell verdeutlicht wird.

Da sich die Tripellinie 42 grundsätzlich nur an der oberen Kante der Seitenfläche-gegebenenfalls in gewünschter Höhe auf der Seitenfläche - einstellt, die der Transportrichtung 36 abgewandt ist, erfindungsgemäß jedoch jede Seitenfläche 14, 16, 18, 20 im gewünschten Umfang oberflächenseitig abzuätzen ist, wird das Substrat 10 während des Transports durch die Prozesskammer 24 entsprechend gedreht, also bei einem quaderförmigen Substrat insgesamt dreimal jeweils um 90°.

Insbesondere ist vorgesehen, dass das Substrat 10 mit dem Prozessmedium 26 über eine Dauer wechselwirkt, die einen Ätzabtrag an der Unterseitenfläche 12 sowie den Seitenflächen 14, 16, 18, 20 zwischen 0,5 µm und 3 µm, insbesondere im Bereich von 1 µm bewirkt.

Dieser Ätzabtrag dient zur Eliminierung von Oxidschichten, Materialschäden wie z. B. Rissen, Mikrorissen oder Oberflächenrauigkeiten und Texturen und insbesondere bei einer vorausgegangenen Beaufschlagung mit einem Dotiermittel, das bei vorhandener Dotierschicht einer anwendungstypischen Weiterverarbeitung für zum Beispiel einer Solarzelle zur Ausbildung eines pn- beziehungsweise np-Übergangs dient.

Somit kann das Entfernen eines entsprechenden pn- beziehungsweise np-Übergangs im Bereich der Unterseitenfläche 12 sowie der Seitenflächen 14, 16, 18, 20 über deren jeweiligen gesamte Erstreckung als ein verfahrenstypisches Merkmal der Erfindung bei der Prozessierung von Substraten in Form von dotierten Wafern angesehen werden, die für die Herstellung von Solarzellen bestimmt sind.

Auf einen entsprechenden Anwendungsfall ist die Erfindung nicht beschränkt. Gleiches gilt im Bezug auf den Umfang des Ätzabtrages. So ist ohne Weiteres die Möglichkeit gegeben, dass ein Ätzabtrag an der Unterseitenfläche 12 und den Seitenflächen 14, 16, 18, 20 zwischen 5 µm und 60 µm, insbesondere im Bereich von 20 µm verfolgt. In diesem Fall dient der Ätzabtrag insbesondere zur Eliminierung einer Oberflächenrauigkeit, welche in einer anwendungstypischen Weiterverarbeitung zur Herstellung einer nur vorderseitig vorhandenen Oberflächentextur auf einer Solarzelle dient. Die Aufhebung der Oberflächentextur auf der Unterseitenfläche sowie den Seitenflächen kann gleichfalls als verfahrenstypisches Merkmal der Erfindung angesehen werden.

Ohne die Erfindung zu verlassen, besteht weiterhin die Möglichkeit, dass die Siliziumscheibe vor der erfindungsgemäßen Weiterprozessierung einem einseitigen Ätzprozess gemäß dem Stand der Technik unterworfen wird, der zu einer Oberflächenrauigkeit bzw. -textur nur auf der geätzten Oberfläche führt.

Zur Eliminierung der noch verbliebenen oberflächlichen Schädigung der Siliziumscheibe auf der nicht zuvor geätzten Oberfläche und den Seitenflächen 14, 16, 18, 20 wird ein Ätzabtrag an der Unterseite 12 und den Seitenflächen 14, 16, 18, 20 der Scheibe zwischen 1 µm und 100 µm eingestellt, vornehmlich ein Ätzabtrag zwischen 5 µm und 20 µm, der zu einer glatten Oberfläche führt. Dadurch wird nicht nur die gewünschte Beseitigung von Oberflächenschädigungen unter Erzielung von glatten Seitenflächen 14, 16, 18, 20 und damit eine verbesserte mechanische Belastbarkeit erreicht, sondern auch eine für die später daraus hergestellten Solarzellen vorteilhafte Morphologie der Scheibenoberflächen (einseitige Oberflächentextur) durch eine gezielt selektive und damit sparsame Ätzung.

Durch den Abtrag der Rauigkeiten in der Unterseitenfläche 12 bzw. den Seitenflächen 14, 16, 18, 20 und damit der Eliminierung von Materialschäden und Rissen erfährt das Substrat 10 insbesondere bei der Behandlung dünner Siliziumsscheiben eine Verbesserung der Festigkeit. Versuche haben ergeben, dass bei einer 156 mm x 156 mm großen und 180 µm dicken Siliziumscheibe eine Verbesserung der Bruchfestigkeit um über 50 % erreichbar ist.

Ätzabträge im Bereich zwischen 1 µm und 100 µm, insbesondere im Bereich zwischen 5 µm und 20 µm, führen zum Eliminieren oberflächlicher Schädigungen des Substrats 10 durch mechanische Prozesse wie Sägen, Fräsen, Schleifen oder auch andere typische Schneidveifahren wie Laserverfahren.

Durch das Beseitigen der Oberflächenbeschädigungen sowohl an den Unterseitenflächen 12 als auch an den Seitenflächen 14, 16, 18, 20 wird erreicht, dass bei mechanischen Belastungen, die insbesondere durch ein nach der Prozessierung erfolgendes Handling gegeben sind, die Bruchfestigkeit der Substrate 10 erheblich erhöht wird.

Da erfindungsgemäß vorgesehen ist, dass ein Wechselwirken und damit Abätzen des Substrats 10 ausschließlich an der Unterseitenfläche 12 sowie den Seitenflächen 14, 16, 18, 20 erfolgt, wird ein Benetzen der Oberseitenfläche 22 dadurch vermieden, dass die Oberflächenseite 22 hydrophob ist.

Die hydrophoben Eigenschaften können durch eine - wie zuvor beschriebene - Vorbehandlung des Substrats 10 und/oder während des Wechselwirkens des Substrats 10 mit den Gasen des Prozessmediums 26 in der Prozesskammer 24 eingestellt werden. So kann während des chemischen Ätzens der Substratunterseite 12 sowie der Seitenflächen 14, 16, 18, 20 oberhalb des Prozessmediums 26 und damit über der Substratoberseitenfläche 22 eine Atmosphäre eingestellt werden, die neben Luft auch HF-, NOX- und HNO₃-haltige Gasanteile sowie Wasserdampf enthält, wobei die Partialdrücke der Komponenten so eingestellt werden, dass sich auf der Oberflächenseite 22 des Substrats 10 eine feinporige poröse Schicht ausbildet. Gleichzeitig werden etwaige Oxidschichten abgetragen. Hierdurch wird eine verstärkt hydrophobe Oberfläche durch den erzielten Lotusblüteneffekt erreicht, um somit ein Benetzen durch das Prozessmedium 26 dem Grunde nach vermieden. Dabei werden vorteilhaft die bei der Ätzung der Substratunterseitenfläche 12 sowie der Seitenflächen 14, 16, 18, 20 entstehenden nitrose Gase genutzt. Ferner kann durch die beim Ätzen freigesetzte Reaktionswärme in Verbindung mit den austretenden NOX-Reaktionsgasen HF, HNO₃ und Wasser in die Gasatmosphäre freigesetzt werden. Durch geeignete Parameterwahl der Ätzbadzusammensetzungen und -temperatur sich einstellende Partialdrücke von HF, HNO₃, NO₂ in Kombination mit dem Wasserdampf sowie ein ergänzender dynamischer Austausch des vorhandenen Gasgemisches aus dem Reaktionsraum 21 durch Absaugen von Gasen und Zumischung von Gasen gewünschter Zusammensetzung kann eine hydrophobe Eigenschaften aufweisende Oberseitenfläche 22 generiert werden. Gase werden zum Beispiel über eine Öffnung 51 abgesaugt und Gase gewünschter Zusammensetzungen über eine Öffnung 52 des Gehäuses 24 zugeführt. Dabei können die zugeführten Gase reaktive oder inerte Bestandteile enthalten, um oberhalb des Substrats eine Atmosphäre einer Zusammensetzung vorliegen zu haben, die die gewünschten hydrophoben Eigenschaften auf der Oberseitenfläche 22 herstellt beziehungsweise bewahrt.

Wird bevorzugteiweise die Tripellinie - wie zuvor beschrieben - an der oberen Kante 38 zwischen der in Bezug auf die Bewegungsrichtung abgewandten Rückseitenfläche - im Ausführungsbeispiel der Seitenfläche 14 - und der Oberseitenfläche 22 eingestellt, so wird die erfindungsgemäße Lehre - wie zuvor erwähnt - selbstverständlich nicht verlassen, wenn die Tripellinie in einer gewünschten Höhe auf der jeweiligen Rückseitenfläche 14, 16, 18, 20 eingestellt wird.

Es besteht auch die Möglichkeit, gezielt nur eine oder ausgewählte Seitenflächen 14, 16, 18, 20 im gewünschten Umfang zu prozessieren, also auf dieser beziehungsweise an deren Oberkanten eine Tripellinie einzustellen, und zwar in Abhängigkeit von den nach der erfindungsgemäßen chemischen Behandlung durchzuführenden weiteren Verfahrenschritten. Auch können Oberflächenschichten in den Seitenflächen 14, 16, 18, 20 in unterschiedlicher Dicke abgetragen werden. Entsprechend muss die entsprechende Seitenfläche mehr oder weniger lange bewegungsrichtungsabgewandt ausgerichtet werden.

Anhand der Fig. 5 soll verdeutlicht werden, dass aufgrund der erfindungsgemäßen Lehre die Seitenflächen 14, 16, 18, 20 und die Unterseitenfläche 12 abgetragen werden. So ist durch die gestrichelte Darstellung die Umfangsgeometrie des Substrats 10 vor dessen Behandlung dargestellt. Die durchgezogene Darstellung verdeutlicht rein prinzipiell die Geometrie des Substrats 10 nach dessen erfindungsgemäßer Behandlung.

Des Weiteren vermittelt die Fig. 6, dass durch die chemische Behandlung in dem Prozessmedium 26 die Kanten 38, 48 des Substrats unterschiedlich abgerundet werden. So weist die obere Kante 38 dann, wenn die Heckwelle 40 von dieser ausgeht, also die Tripellinie im Übergangsbereich zwischen der Oberseitenfläche 22 und der Seitenfläche 14 verläuft, einen kleinen Radius R1 als im Bereich der unten abgetragenen Kante 48, also im Übergangsbereich zwischen der Seitenfläche 14 und der Unterseitenfläche 12 auf (Radius R2).

Die unterschiedlichen Radien R1, R2 ergeben sich dadurch, dass im Bereich der Tripellinie der Ätzabtrag geringer als im Bereich der Unterseite des Substrats 10 ist. So sollte das Verhältnis bei Silizium als Substratmaterial in etwa > 1:10, insbesondere 1:20 betragen.

## Patentansprüche

1. Verfahren zur chemischen Behandlung eines eine Unterseitenfläche (12), Oberseitenfläche (22) und Seitenflächen (14, 16, 18, 20) aufweisenden vorzugsweise scheiben- oder plattenförmigen Substrats (10) durch Kontaktieren eines flüssigen chemisch wirksamen Prozessmediums (26) mit zumindest der Unterseitenfläche des Substrats, wobei das Substrat relativ zum Prozessmedium bei gleichzeitiger Ausbildung einer Tripellinie (42) zwischen Substrat, dem Prozessmedium und diese umgebender Atmosphäre bewegt wird und eine chemische Abtragsreaktion erzielt wird,
**dadurch gekennzeichnet,**
**dass** die Relativbewegung unter Vermeidung eines Kontaktierens des Prozessmediums mit der Oberseitenfläche (22) des Substrats (10) durchgeführt wird, dass die Tripellinie (42) in Bezug auf die Relativbewegung zwischen dem Substrat und dem Prozessmedium (36) auf gewünschter Höhe an prozessmediumströmungsseitig abgewandter Seitenfläche (14, 16, 18, 20) ausgebildet wird, dass die Atmosphäre in Bezug auf Partialdrücke von in dem Prozessmedium vorhandenen Komponenten derart eingestellt wird, dass in der Oberseitenfläche hydrophobe Eigenschaften ausgebildet werden und dass das Substrat um eine senkrecht zur von dem Substrat aufgespannten Ebene verlaufende Achse in einem Umfang gedreht wird, dass von jeder zwischen der Oberseitenfläche und den Seitenflächen verlaufenden oberen Kante (38) des Substrats oder von den Seitenflächen während der chemischen Behandlung eine Tripellinie ausgeht.

2. Verfahren nach Anspruch 1,
**dadurch gekennzeichnet,**
**dass** die Tripellinie (42) an prozessmediumströmungsseitig abgewandter Kante (38) zwischen der Oberseitenfläche (22) und Seitenfläche (14, 16, 18, 20) des Substrats ausgebildet wird.

3. Verfahren nach Anspruch 1,
**dadurch gekennzeichnet,**
**dass** - das Substrat (10), wie Halbleitersubstrat, insbesondere Silizium-Halbleitersubstrat, relativ zu dem Prozessmedium (26) bei gleichzeitiger Ausbildung einer von dem Substrat ausgehenden aus dem Prozessmedium bestehenden Heckwelle (40) bewegt wird, die von der Kante (38) oder der von der Kante begrenzten Seitenfläche (14, 16, 18, 20) ausgeht.

4. Verfahren nach zumindest einem der vorhergehenden Ansprüche,
**dadurch gekennzeichnet,**
**dass** die chemische Behandlung in einem Umfang erfolgt, dass das Substrat (10) nach der Behandlung glatte Unterseiten- und Seitenflächen (12, 14, 16, 18, 20) aufweist, wobei insbesondere durch die chemische Behandlung eine Schichtdicke zwischen 1 µm und 100 µm abgetragen wird.

5. Verfahren nach zumindest einem der vorhergehenden Ansprüche,
**dadurch gekennzeichnet,**
**dass** als Substrat (10) ein zumindest in der Unterflächenseite (12) und/oder zumindest in einer Seitenfläche (14, 16, 18, 20) dotiertes Halbleitersubstrat, wie Silizium-Substrat mit pn-Übergang, verwendet wird, und dass der dotierte Bereich durch die chemische Behandlung entfernt wird.

6. Verfahren nach zumindest einem der vorhergehenden Ansprüche,
**dadurch gekennzeichnet,**
**dass** als Substrat (10) ein solches verwendet wird, das in Draufsicht eine quadratische, pseudo-quadratische, rechteckige oder kreisförmige Geometrie aufweist, insbesondere ein solches verwendet wird, das eine Dicke d mit 50 µm ≤ d ≤ 500 µm, insbesondere 100 µm ≤ d ≤ 200 µm aufweist, wobei vorzugsweise das Substrat (10) mit einer in Draufsicht eckigen Geometrie mit Kanten (38) verwendet wird, von denen zumindest eine, vorzugsweise jede Kante eine Länge L mit 100 mm ≤ L ≤ 350 mm, insbesondere 125 mm ≤ L ≤ 156 mm aufweist.

7. Verfahren nach zumindest einem der vorhergehenden Ansprüche,
**dadurch gekennzeichnet,**
**dass** das Substrat (10) unter zumindest bereichsweiser Benetzung der Seitenflächen (14, 16, 18, 20) durch das Prozessmedium (26) relativ zu diesem bewegt wird, wobei vorzugsweise das Substrat nach einer etwaigen Vorbehandlung mit dem Prozessmedium (26) über eine Zeit t_{H} mit 5sec. ≤ t_{H} ≤ 10 min, insbesondere 15 sec. ≤ t_{H} ≤ 5 min. wechselwirkt.

8. Verfahren nach zumindest einem der vorhergehenden Ansprüche,
**dadurch gekennzeichnet,**
**dass** als Prozessmedium (26) ein solches verwendet wird, das als Komponenten zumindest eine wässrige Säure mit in Bezug auf das Substrat (10) oxidativer Wirkung und zumindest eine wässrige Säure mit in Bezug auf das Oxid des Substratmaterials komplexierende Wirkung enthält, vorzugsweise als Prozessmedium (26) ein solches verwendet wird, das Komponenten enthält aus der Gruppe H₂O, HF, HNO₃, HCl, Oxidationsmittel wie H₂O₂, NO₂, Ammoniumfluorid, Essigsäure, Schwefelsäure, Phosphorsäure, oder als Prozessmedium (26) ein solches verwendet wird, das zumindest wässrige Flusssäure und wässrige Salpetersäure enthält, wobei vorzugsweise als Prozessmedium (26) ein solches verwendet wird, bei dem dessen Säurebestandteile zwischen 0,1 Vol.% und 70 Vol.% betragen, wobei die Summe sämtlicher Komponenten in dem Prozessmedium 100 Vol.% ist, oder als Prozessmedium (26) ein solches verwendet wird, bei dem der Anteil von HF zwischen 0,1 Gew.% und 20 Gew.% und der Anteil von HNO₃ zwischen 20 Gew.% und 70 Gew.% beträgt, wobei die Summe sämtlicher Komponenten in dem Prozessmedium 100 Gew.% ist, insbesondere als Prozessmedium (26) ein solches verwendet wird, bei dem der Gewichtsanteil von HF zu HNO₃ sich verhält wie 1:8 ≤ HF : HNO₃ ≤ 1:3.

9. Verfahren nach zumindest einem der vorhergehenden Ansprüche,
**dadurch gekennzeichnet,**
**dass** die chemische Behandlung bei einer Temperatur T des Prozessmediums mit 5 °C ≤ T ≤ 45 °C, vorzugsweise 10 °C ≤ T ≤ 25 °C, insbesondere 5 °C ≤ T < T_{R} mit T_{R} = Raumtemperatur durchgeführt wird.

10. Verfahren nach zumindest einem der vorhergehenden Ansprüche,
**dadurch gekennzeichnet,**
**dass** das Substrat (10) vor der chemischen Behandlung zumindest in seiner Oberflächenseite (22) mit hydrophoben Eigenschaften versehen wird.

11. Verfahren nach zumindest Anspruch 10,
**dadurch gekennzeichnet,**
**dass** zumindest die Oberflächenseite oxidfrei und/oder glatt ausgebildet wird.

12. Verfahren nach zumindest einem der vorhergehenden Ansprüche,
**dadurch gekennzeichnet,**
**dass** das Substrat (10) mit einer wässrigen Lösung von Flusssäure mit einer Konzentration von 0,1 Gew.% bis 40 Gew.%, vorzugsweise von 1 Gew.% bis 10 Gew.%, vorbehandelt wird.

13. Verfahren nach zumindest einem der vorhergehenden Ansprüche,
**dadurch gekennzeichnet,**
**dass** das Substrat (10) bei einer Temperatur Tᵥ mit 5 °C ≤ Tᵥ ≤ 65 °C, vorzugsweise 20 °C ≤ Tᵥ ≤ 45 °C, insbesondere 20 °C ≤ Tᵥ ≤ 40 °C vorbehandelt wird, wobei insbesondere die Vorbehandlung über eine Zeit t mit einer 1 sec. ≤ t ≤ 10 min., insbesondere 5 sec. ≤ t ≤ 60 sec. durchgeführt wird.

14. Verfahren nach zumindest einem der vorhergehenden Ansprüche,
**dadurch gekennzeichnet,**
**dass** die chemische Behandlung bei einer Relativgeschwindigkeit V zwischen dem Substrat (10) und dem Prozessmedium (26) mit 0,1 m/min. ≤ V ≤ 10 m/min., vorzugsweise 0,5 m/min. ≤ V ≤ 5 m/min. durchgeführt wird, wobei insbesondere das Substrat (10) durch das Prozessmedium (26) geführt wird.

15. Verfahren nach zumindest einem der vorhergehenden Ansprüche,
**dadurch gekennzeichnet,**
**dass** während der chemischen Behandlung die Komponenten der die Oberseite (22) des Substrats (10) umgebenden Atmosphäre derart eingestellt werden, dass der Partialdruck der Säure mit oxidierender Wirkung wie HNO₃ gleich oder in etwa gleich oder kleiner dem Partialdruck der Säure mit komplexierender Wirkung wie HF ist, oder dass während der chemischen Behandlung die Atmosphäre durch gezielte Zugabe inaktiver und/oder reaktiver Gaskomponenten derart verändert wird, dass sich eine ätzende Wirkung von der auf die Oberflächenseite (22) einwirkenden Atmosphäre ergibt, wobei insbesondere die Atmosphäre durch Zugabe von HF-Dampf zwischen 100 mg/m³ und 1.000 mg/m³, und/oder HNO₃-Dampf im Bereich zwischen 100 mg/m³ und 3.000 mg/m³ und/oder inerte Gase wie Stickstoff oder Argon und/oder Luft mit einer Austauschrate zwischen 10-mal bis 100-mal pro Stunde ausgetauscht wird.

## Claims

1. Method for the chemical treatment of a preferably wafer- or plate-shaped substrate (10) having a bottom surface (12), a top surface (22) and lateral surfaces (14, 16, 18, 20) by means of making contact with a liquid, chemically effective process medium (26) with at least the bottom surface of the substrate, wherein the substrate is moved relative to the process medium during the simultaneous formation of a triple-line (42) between substrate, the process medium and the atmosphere that surrounds it, and a chemical ablation reaction is achieved,
**characterized in**
**that** the relative movement is performed while avoiding a contact of the process medium with the top surface (22) of the substrate (10), that the triple-line (42) is formed in reference to the relative movement between the substrate and the process medium (36) at the desired height on the lateral surface (14, 16, 18, 20) that is facing away from the stream side of the process medium, that the atmosphere is adjusted in regard to the partial pressures of the components present in the process medium in such a manner that in the top surface hydrophobic properties develop and that the substrate is rotated about an axis that runs perpendicularly to the plane defined by the substrate, that during the chemical treatment a triple-line originates from every upper edge (38) of the substrate, said edge running between the top surface and the lateral surfaces, or from the lateral surfaces.

2. Method according to claim 1,
**characterized in**
**that** the triple-line (42) is formed at the edge (38) facing away from the stream side of the process medium between the top surface (22) and lateral surface (14, 16,18,20).

3. Method according to claim 1,
**characterized in**
**that** the substrate (10), such as semiconductor substrate, especially silicon semiconductor substrate, is moved relative to the process medium (26) during the simultaneous formation of a wake (40) that originates from the substrate and consists of the process medium and that originates from the edge (38) or from the lateral surface (14, 16, 18, 20) that is delimited by the edge.

4. Method according to at least one of the preceding claims,
**characterized in**
**that** the chemical treatment takes place to an extent that the substrate (10) features smooth bottom and lateral surfaces (12, 14, 16, 18, 20) after the treatment, whereby especially a layer thickness between 1 µm and 100 µm is ablated by means of the chemical treatment

5. Method according to at least one of the preceding claims,
**characterized in**
as a substrate (10) is used a semiconductor substrate, such as a silicon substrate with pn junction, that is doped at least in the bottom surface (12) and/or at least in one lateral surface (14, 16, 18, 20), and that the doped area is removed by means of the chemical treatment.

6. Method according to at least one of the preceding claims,
**characterized in**
**that** as a substrate (10) is used one that features, in plan view, a quadratic, pseudo-quadratic, rectangular or circular geometry, is used especially one that features a thickness d with 50 µm ≤ d ≤ 500 µm, in particular 100 µm ≤ d ≤ 200 µm, whereby preferably that substrate (10) is used that features, in plan view, an angled geometry with edges (38) of which at least one, preferably every edge, features a length L with 100 mm ≤ L ≤ 350 mm, in particular 125 mm ≤ L ≤ 156 mm.

7. Method according to at least one of the preceding claims,
**characterized in**
**that** the substrate (10) is moved relative to the process medium (26) while the latter wets at least area-wise the lateral surfaces (14, 16, 18, 20), whereby preferably the substrate interacts after a possible pretreatment with the process medium (26) over a time period t_{H} of 5 sec. ≤ t_{H} ≤ 10 min, in particular 15 sec. ≤ t_{H} ≤ 5 min.

8. Method according to at least one of the preceding claims,
**characterized in**
**that** as process medium (26) is used one that contains as components at least one aqueous acid with oxidative effect in regard to the substrate (10) and at least one aqueous acid with a complexing effect in regard to the oxide of the substrate material, that as process medium (26) is used preferably one that contains components from the group H₂O, HF, HNO₃, HCl, oxidation means such as H₂O₂, NO₂, ammonium fluoride, acetic acid, sulphuric acid, phosphoric acid, or that as process medium (26) is used one which includes at least aqueous hydrofluoric acid and aqueous nitric acid, whereby preferably is used as process medium (26) one the acid components of which amount to between 0.1 vol. % and 70 vol. %, wherein the sum of all components in the process medium amount to 100 vol. %, or that as a process medium (26) is used one where the proportion of HF amounts to between 1.0 wt. % and 20 wt. % and the proportion of HNO₃ amounts to between 20 wt. % and 70 wt. %, whereby the sum of all components in the process medium is 100 wt. %, that especially as process medium (26) is used one where the weight ratio of HF to HNO₃ is as 1:8 ≤ HF:HNO₃ ≤ 1:3.

9. Method according to at least one of the preceding claims,
**characterized in**
**that** the chemical treatment is performed at a temperature T of the process medium with 5°C ≤ T ≤ 45°C, preferably 10°C ≤ T ≤ 25°C, in particular 5°C ≤ T < T_{R} with T_{R} = room temperature.

10. Method according to at least one of the preceding claims,
**characterized in**
**that** prior to the chemical treatment the substrate (10) is provided at least in its top surface (22) with hydrophobic properties.

11. Method according to claim 10,
**characterized in**
**that** at least the top surface is designed oxide-free and/or smooth.

12. Method according to at least one of the preceding claims,
**characterized in**
**that** the substrate (10) is pretreated with an aqueous solution of hydrofluoric acid with a concentration of between 0.1 wt. % and 40 wt. %, preferably between 1 wt. % and 10 wt. %.

13. Method according to at least one of the preceding claims,
**characterized in**
**that** the substrate (10) is treated at a temperature Tᵥ with 5°C ≤ Tᵥ ≤ 65°C, preferably 20°C ≤ Tᵥ ≤ 45°C., in particular 20°C ≤ Tᵥ ≤ 45°C, whereby especially the pretreatment is executed over a time t of 1 sec. ≤ t ≤ 10 min., in particular 5 sec. ≤ t ≤ 60 sec.

14. Method according to at least one of the preceding claims,
**characterized in**
**that** the chemical treatment is executed at a relative velocity V between the substrate (10) and the process medium (26) of 0.1 m/min. ≤ V ≤ 10 m/min., preferably 0.5 m/min. ≤ V ≤ 5 m/min., whereby especially the substrate is guided through the process medium (26).

15. Method according to at least one of the preceding claims,
**characterized in**
**that** during the chemical treatment the components of the atmosphere that surrounds the top surface (22) of the substrate (10) is adjusted in such a manner that the partial pressure of the acid with oxidizing effect, such as HNO₃, is equal or approximately equal or smaller than the partial pressure of the acid with complexing effect, such as HF, or that during the chemical treatment the atmosphere is modified through the specific addition of inactive and/or reactive gas components in such a manner that an etching effect by the atmosphere acting on the top surface (22) results, whereby especially the atmosphere is exchanged by means of the addition of HF vapor between 100 mg/m³ and 1,000 mg/m³, and/or HNO₃-vapor in the range between 100 mg/m³ and 3,000 mg/m³ and/or inert gases such as nitrogen or argon and/or air at an exchange rate between 10-times to 100-times per hour.

## Revendications

1. Procédé de traitement chimique d'un substrat (10) en forme de disque ou de plaque présentant une face inférieure (12), une face supérieure (22) et des faces latérales (14, 16, 18, 20), de préférence par mise en contact d'un agent de traitement (26) liquide chimiquement actif avec au moins la face inférieure du substrat, sachant que le substrat est mis en mouvement par rapport à l'agent de traitement avec formation simultanée d'une ligne triple (42) entre le substrat, l'agent de traitement et l'atmosphère les entourant, et qu'une réaction d'érosion chimique est obtenue,
**caractérisé en ce**
**que** le mouvement relatif est effectué en évitant un contact de l'agent de traitement avec la face supérieure (22) du substrat (10), que par rapport au mouvement relatif entre le substrat et l'agent de traitement (36), la ligne triple (42) est formée à la hauteur souhaitée sur la face latérale (14, 16, 18, 20) opposée au côté de l'écoulement de l'agent de traitement, que par rapport aux pressions partielles des composants présents dans l'agent de traitement, l'atmosphère est ajustée de manière telle que sont développées des propriétés hydrophobes dans la face supérieure, et que le substrat est pivoté autour d'un axe perpendiculaire au plan décrit par le substrat d'une valeur telle que pendant le traitement chimique une ligne triple part de chaque arête supérieure (38) s'étendant entre la face supérieure et les faces latérales du substrat ou des faces latérales.

2. Procédé selon la revendication 1,
**caractérisé en ce**
**que** la ligne triple (42) sur l'arête (38) opposée au côté de l'écoulement de l'agent de traitement est formée entre la face supérieure (22) et la face latérale (14, 16, 18, 20) du substrat.

3. Procédé selon la revendication 1,
**caractérisé en ce**
**que** le substrat (10), tel qu'un substrat semi-conducteur, en particulier un substrat semi-conducteur au silicium, est mis en mouvement par rapport à l'agent de traitement (26) avec formation simultanée d'un sillage (40) issu du substrat, constitué de l'agent de traitement et partant de l'arête (38) ou de la face latérale (14, 16, 18, 20) délimitée par l'arête.

4. Procédé selon au moins une des revendications précédentes,
**caractérisé en ce**
**que** le traitement chimique a lieu dans une mesure telle que le substrat (10) présente une face inférieure et des faces latérales (12, 14, 16, 18, 20) lisses après le traitement, sachant qu'en particulier une épaisseur de couche comprise entre 1 µm et 100 µm est enlevée par le traitement chimique.

5. Procédé selon au moins une des revendications précédentes,
**caractérisé en ce**
**qu'**en tant que substrat (10) est mis en oeuvre un substrat semi-conducteur, tel qu'un substrat au silicium avec jonction PN, dopé au moins dans la face inférieure (12) et/ou au moins dans une face latérale (14, 16, 18, 20), et que la zone dopée est enlevée par le traitement chimique.

6. Procédé selon au moins une des revendications précédentes,
**caractérisé en ce**
**qu'**est mis en oeuvre un substrat (10) présentant en élévation une géométrie carrée, pseudo-carrée, rectangulaire ou circulaire, en particulier un substrat présentant une épaisseur d telle que 50 µm ≤ d ≤ 500 µm, en particulier 100 µm 1:8 ≤ d ≤ 200 µm, sachant que de préférence est mis en oeuvre le substrat (10) ayant en élévation une géométrie polygonale avec arêtes (38), parmi lesquelles au moins une, de préférence chaque arête, présente une longueur L telle que 100 mm ≤ L ≤ 350 mm, en particulier 125 mm ≤ L ≤ 156 mm.

7. Procédé selon au moins une des revendications précédentes,
**caractérisé en ce**
**que** le substrat (10) est mis en mouvement sous humectation au moins partielle des faces latérales (14, 16, 18, 20) par l'agent de traitement (26) et relativement à celui-ci, sachant que de préférence après un prétraitement éventuel, le substrat interagit avec l'agent de traitement (26) pendant une durée t_{H} telle que 5 s ≤ t_{H} ≤ 10 min, en particulier 15 s ≤ t_{H} ≤ 5 min.

8. Procédé selon au moins une des revendications précédentes,
**caractérisé en ce**
**qu'**est mis en oeuvre un agent de traitement (26) contenant comme composants au moins un acide aqueux ayant un effet oxydatif sur le substrat (10) et au moins un acide aqueux ayant un effet complexant sur l'oxyde du matériau du substrat, sachant que de préférence est mis en oeuvre un agent de traitement (26) contenant des composants issus des groupes H₂O, HF, HNO₃, HCl, oxydants tels que H₂O₂, NO₂, fluorure d'ammonium, acide acétique, acide sulfurique, acide phosphorique, ou qu'est mis en oeuvre un agent de traitement (26) contenant au moins de l'acide fluorhydrique aqueux et de l'acide nitrique aqueux, sachant que de préférence est mis en oeuvre un agent de traitement (26) dont la part de composants acides est comprise entre 0,1 % et 70 % en volume, la somme de tous les composants dans l'agent de traitement étant égale à 100 % en volume, ou qu'est mis en oeuvre un agent de traitement (26) dont la part de HF est comprise entre 0,1 % et 20 % en poids et la part de HNO₃ entre 20 % et 70 % en poids, la somme de tous les composants dans l'agent de traitement étant égale à 100 % en poids, qu'en particulier est mis en oeuvre un agent de traitement (26) dans lequel le rapport entre les parts en poids de HF et de HNO₃ est tel que 1:8 ≤ HF : HNO₃ ≤ 1:3.

9. Procédé selon au moins une des revendications précédentes,
**caractérisé en ce**
**que** le traitement chimique est effectué sous une température T de l'agent de traitement telle que 5 °C ≤ T ≤ 45 °C, de préférence 10°C ≤ T ≤ 25 °C, en particulier 5 °C ≤ T < T_{R}, où T_{R} = température ambiante.

10. Procédé selon au moins une des revendications précédentes,
**caractérisé en ce**
**que** le substrat (10) est doté de propriétés hydrophobes au moins dans sa face supérieure (22) avant le traitement chimique.

11. Procédé selon au moins la revendication 10,
**caractérisé en ce**
**qu'**au moins la face supérieure est conçue exempte d'oxydes et/ou lisse.

12. Procédé selon au moins une des revendications précédentes,
**caractérisé en ce**
**que** le substrat (10) est prétraité avec une solution aqueuse d'acide fluorhydrique ayant une concentration comprise entre 0,1 % et 40 % en poids, de préférence entre 1 % et 10 % en poids.

13. Procédé selon au moins une des revendications précédentes,
**caractérisé en ce**
**que** le substrat (10) est prétraité sous une température Tᵥ telle que 5 °C ≤ Tᵥ ≤ 65 °C, de préférence 20 °C ≤ Tᵥ ≤ 45 °C, en particulier 20 °C ≤ Tᵥ ≤ 40 °C, sachant qu'en particulier le prétraitement est effectué pendant une durée t telle que 1 s ≤ t ≤ 10 min, en particulier 5 s ≤ t ≤ 60 s.

14. Procédé selon au moins une des revendications précédentes,
**caractérisé en ce**
**que** le traitement chimique est effectué avec une vitesse relative V entre le substrat (10) et l'agent de traitement (26) telle que 0,1 m/min ≤ V ≤ 10 m/min, de préférence 0,5 m/min ≤ V ≤ 5 m/min, sachant qu'en particulier le substrat (10) est guidé à travers l'agent de traitement (26).

15. Procédé selon au moins une des revendications précédentes,
**caractérisé en ce**
**que** pendant le traitement chimique, les composants de l'atmosphère entourant la face supérieure (22) du substrat (10) sont ajustés de manière telle que la pression partielle de l'acide avec effet oxydant, tel que du HNO₃, est égale, approximativement égale ou inférieure à la pression partielle de l'acide avec effet complexant, tel que du HF, ou que pendant le traitement chimique, l'atmosphère est modifiée par addition ciblée de composants gazeux inertes et/ou réactifs de manière telle qu'il en résulte un effet corrosif de l'atmosphère agissant sur la face supérieure (22), sachant qu'en particulier selon un taux de renouvellement compris entre 10 et 100 fois par heure, l'atmosphère est renouvelée par addition de vapeur de HF entre 100 mg/m³ et 1000 mg/m³, et/ou de vapeur de HNO₃ dans la plage de 100 mg/m³ à 3000 mg/m³ et/ou de gaz inertes tels qu'azote ou argon et/ou d'air.
